# EUROPÄISCHE PATENTSCHRIFT

(11) **EP 0 641 154 B1**
(45) Veröffentlichungstag und Bekanntmachung des Hinweises auf die Patenterteilung: **09.10.1996**
(21) Anmeldenummer: 94112089.1
(22) Anmeldetag: 03.08.1994
(51) Int. Cl.: H05K 5/00

(54) **Baugruppe zur Aufnahme elektronischer Bauelemente**
Housing for electronic components
Boîtier pour composants électroniques

(30) Priorität: 30.08.1993 DE 4329083
(43) Veröffentlichungstag der Anmeldung: 01.03.1995
(73) Patentinhaber: TEMIC TELEFUNKEN microelectronic GmbH, 74072 Heilbronn (DE)
(72) Erfinder: Schirmer, Klaus, Dipl.-Ing., D-85049 Ingolstadt (DE)
(74) Vertreter: Maute, Hans-Jürgen, Dipl.-Ing.

(56) Entgegenhaltungen:
- EP-A- 0 368 142
- WO-A-92/12875
- DE-U- 7 909 986

## Beschreibung

Die Erfindung betrifft eine elektronische Baugruppe mit einer elektronische Bauelemente tragenden Leiterplatte gemäß dem Oberbegriff des Patentanspruchs 1.

Baugruppen für elektronische Bauelemente, insbesondere für Kfz-Elektronik müssen zunehmend hohen Ansprüchen an Funktion, Qualität und Zuverlässigkeit genügen. Diesen Ansprüchen werden jedoch im Hinblick auf Wirtschaftlichkeit Grenzen gesetzt. Daher kommen insbesondere im Kfz-Bereich solche Technologien zum Einsatz, die gleichzeitig den hohen technischen Ansprüchen genügen als auch kosteneffizient herstellbar sind.

So ist aus der DE-OS 41 02 265 eine Baugruppe für Kfz-Elektronik bekannt, bei der eine Metallplatte als Träger für eine Multilayer-Leiterplatte oder eine Multilayer-Folie und gleichzeitig als Wärmesenke für die auf der Leiterplatte bzw. Folie angeordneten Bauelemente als auch als Teil des Gehäuses andererseits dient. Die Baugruppe wird dadurch zu einem vollständigen Gehäuse komplettiert, indem ein haubenförmig ausgebildeter Deckel die die Leiterplatte bzw. Folie tragende Seite der Metallplatte formschlüssig abdeckt. Darüber hinaus kann der zwischen dem Deckel und der Leiterplatte entstehende Raum mit einem isolierenden und feuchtigkeitsabweisenden Material unter Bildung eines Vergusses ausgefüllt werden.

Ein kritischer Punkt bei dieser bekannten Baugruppe ist nach wie vor die hermetisch dichte Verpackung der Bauelemente als auch der Leiterplatte, da zwischen der in der Regel aus Kunststoff bestehenden Gehäusekappe und der Metallplatte Undichtigkeiten entstehen können. Eine die Zuverlässigkeit steigernde Maßnahme wäre die Herstellung eines Voll- oder Teilvergusses als Weichverguß durch Ausgießen des Hohlraumes zwischen Gehäusekappe und Leiterplatte mit Silikon-Gel. Aufgrund der hohen Materialkosten von Silikon führt dies jedoch zu hohen Herstellungskosten. Darüber hinaus führt der hohe thermische Ausdehnungskoeffizient des Silikon-Gels zu mechanischen Problemen.

Daher stellt sich die Erfindung die Aufgabe, eine Baugruppe der eingangs genannten Art anzugeben, die bei niedrigen Herstellungskosten höchste Zuverlässigkeit im Hinblick auf die Abdichtung der Bauelemente und der Leiterplatte bietet.

Diese Aufgabe wird durch die kennzeichnenden Merkmale des Patentanspruches 1 gelöst.

Die damit vorgeschlagene Lösung wendet in der Baugruppentechnologie zum ersten Mal die aus der IC-Technologie bekannte Gehäusetechnik an, nämlich das Gehäuse durch Umpressen der IC-Chips mit einer Mouldmasse, als Hartverguß herzustellen. Die Umpressung bildet am Umfang der Leiterplatte eine formschlüssige Verbindung mit der Metallplatte, so daß diese Umpressung zusammen mit der Metallplatte ein hochwertiges feuchtedichtes Gehäuse bildet, das auch bei zyklischer thermischer Belastung eine hohe Zuverlässigkeit aufweist.

Gemäß einer vorteilhaften Ausführungsform wird die Umpressung so ausgeführt, daß an deren Umfang die Metallplatte übersteht, wodurch sich dort, also an dem Überstand Befestigungsmöglichkeiten ergeben.

In der Regel weisen elektronische Baugruppen Mittel zum Anschluß von Verbindungsleitungen auf, also Stecker, die mit der Leiterplatte verbunden sind. Solche Stecker bestehen aus einem Steckerkern, der die Steckerpins aufnimmt sowie einem Steckerrahmen, der zur Führung der Buchse dient sowie mit einer Dichtung und Verrastung versehen ist. Bei einer solchen Ausführungsform wird nun der Steckerrahmen als Umpressung des Steckerkerns gleichzeitig mit der Umpressung der Bauelemente und der Leiterplatte ausgeführt. Somit können die Steckerkosten minimiert werden, da beim Steckerhersteller die Fertigungskosten reduziert werden, was insgesamt zu geringeren Herstellungskosten der Baugruppe führt. Bei einer solchen Ausführungsform ist die Leiterplatte auf der ersten Fläche der Metallplatte angeordnet, während ein solcher Stecker sich auf der zweiten Fläche dieser Metallplatte befindet und beidseitig mit Mouldmasse umgeben ist.

Bei einer anderen bevorzugten Weiterbildung der Erfindung ist der Stecker als Randgruppenstecker ausgebildet. Zur Anbringung eines solchen Randgruppensteckers weist die Metallplatte in deren Randbereich eine Aussparung auf, die so tief ist, daß ein zur Aufnahme des Randgruppensteckers ausreichender Randbereich der Leiterplatte in diese Aussparung ragt, wobei dieser Randbereich der Leiterplatte mit der Mouldmasse nicht umpreßt wird. Da bei einer solchen Ausführungsform der eigentliche Stecker sich kabelseitig befindet, weist die Baugruppe keinen eigentlichen Stecker mehr auf, wodurch sich insbesondere eine Reduzierung der Gehäusewerkzeugkosten für Stecker, Deckel etc. auf nur ein einziges Werkzeug ergibt.

Bei einer solchen Ausführungsform ist vorzugsweise auf der zweiten Fläche der Metallplatte im Randbereich der den Randgruppenstecker aufnehmenden Leiterplatte eine Umpressung des Kontaktbereichs von Metallplatte und Leiterplatte zwecks Vermeidung des Eindringens von Feuchtigkeit vorgesehen.

Weiterhin kann in vorteilhafter Weise der Randgruppenstecker der o. g. Ausführungsform als Nullkraftstecker ausgeführt sein.

Eine weitere Reduzierung der Herstellungskosten wird dadurch erzielt, daß anstatt mit Gehäuse versehene Bauelemente gehäuselose Bauelemente, also IC-Chips verwendet werden, die nach dem Auflöten auf die Leiterplatte gebondet werden. Die Kosteneinsparung ergibt sich insbesondere dadurch, daß beim Halbleiterhersteller der Fertigungsschritt der Gehäuseherstellung entfällt.

Schließlich kann bei einer letzten vorteilhaften Weiterbildung der Erfindung als Leiterplatte eine Multilayer-Leiterplatte oder eine Multilayer-Folie verwendet werden, wodurch eine optimalere Ausnutzung der vorhandenen Leiterplattenfläche erzielt wird, mit der Folge eines geringen Baugruppen-Volumens.

Im folgenden soll die Erfindung anhand von Ausführungsbeispielen im Zusammenhang mit den Zeichnungen dargestellt und erläutert werden. Es zeigen:
- Figur 1: eine perspektivische Darstellung einer Baugruppe gemäß der Erfindung,
- Figur 2: eine Schnittdarstellung A-A der Baugruppe gemäß Figur 1 und
- Figur 3: eine perspektivische Darstellung einer weiteren Baugruppe gemäß der Erfindung mit einem Randgruppenstecker.

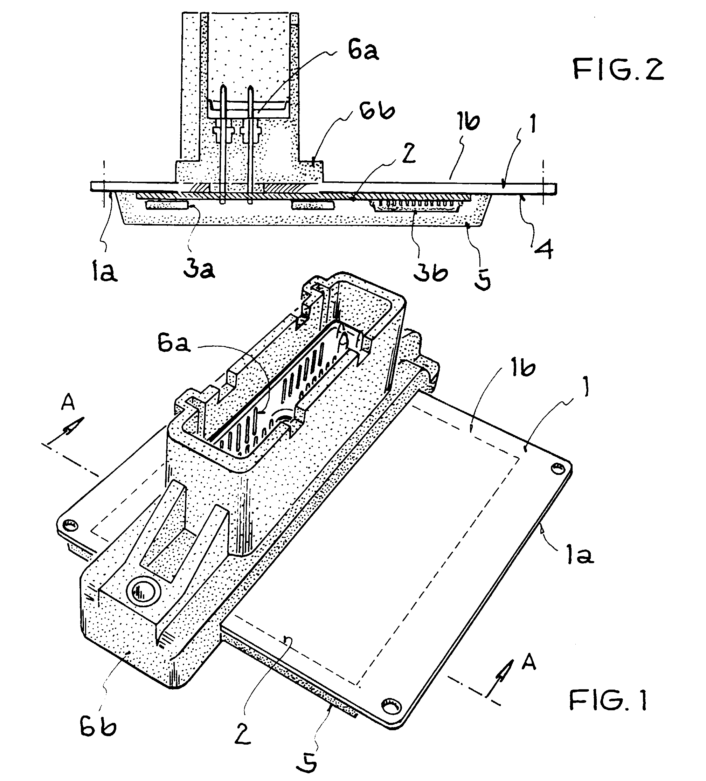

Die Baugruppe gemäß Figur 1 und 2 besteht aus einer Metallplatte 1 aus Aluminium, deren eine Fläche 1a eine Leiterplatte 2 trägt. Diese Leiterplatte 2 kann als Multilayer-Leiterplatte oder als Multilayer-Folie ausgeführt sein, wobei solche Mehrlagen-Platinen mit der Aluminium-Trägerplatte 1 flächenschlüssig verklebt sind. Zur Herstellung einer solchen Multilayer-Folie werden die einzelnen Folien lose übereinander auf die Metallplatte 1 gelegt, wobei zwischen diesen Folien bzw. zwischen der der Metallplatte 1 benachbarten Folie je eine Klebefolie oder eine dünne Kleberschicht mit eingelegt oder aufgebracht wird. Bei einer solchen Folie handelt es sich um eine vorvernetzte, also nicht ausgehärtete Klebefolie mit Glasfilamentgewebe (Prepreg). Die genannten Folien werden unter Anwendung von Druck und Wärme stoffschlüssig miteinander verpreßt. Die Leiterplatte 2 ist in ihrer flächenhaften Ausdehnung etwas kleiner gewählt als die Metallplatte 1, so daß von der Metallplatte 1 ein die Leiterplatte 2 umlaufender Rand 4 gebildet wird.

Die Leiterplatte 2 enthält Leistungstransistoren 3a sowie sonstige elektronische Bauelemente 3, die als SMD-Bauelemente ausgeführt sind. Somit dient die Aluminiumplatte 1 gleichzeitig als Platinenträger, Kühlkörper und Gehäuseboden, wobei die wärmeverteilende Aluminiumplatte 1 für eine optimale Wärmeverteilung sorgt.

Die genannte Baugruppe gemäß den Figuren 1 und 2 weist ferner einen aus einem Steckerkern 6a und einer Steckerführung 6b aufgebauten Stecker auf. Dieser Stecker ist auf der anderen Fläche 1b der Metallplatte 1 in einer zentralen Position angeordnet, so daß zu den Leistungstransistoren 3a möglichst kurze Leitungswege entstehen.

Zur Vervollständigung der Baugruppe wird die Leiterplatte 2 mit den elektronischen Bauelementen 3 und 3a und gleichzeitig der Steckerkern 6a mittels einer Mouldmasse 5 derart umpreßt, daß zusammen mit der Metallplatte 1 ein geschlossenes Gehäuse entsteht. Dieses Gehäuse besteht neben der Metallplatte einmal aus der Umpressung 5 der Leiterplatte und den Bauelementen sowie einer Umpressung 6b, die den Steckerrahmen mit Dichtung und Verrastung bildet. Diese Umpressung ist aus der IC-Technologie unter dem Begriff "Moulden" bekannt und kann beispielsweise mit einer von der Fa. Ciba Geigy auf dem Markt angebotenen Mouldmasse Aratronic 2180-4 ausgeführt werden, deren geringer thermischer Ausdehnungskoeffizient das Moulden derart großer Volumen möglich macht.

Die Umpressung 5 und 6b werden in einem einzigen Vorgang erzeugt und bilden einerseits mit der Fläche 1a der Metallplatte 1 am umlaufenden Rand der Leiterplatte 2 eine feuchtedichte Verbindung mit der Metallplatte und andererseits eine ebensolche formschlüssige Verbindung mit dem Steckerkern 6a bzw. der Fläche 1b der Metallplatte. Da der Steckerrahmen 6a aus einem thermoplastischen Kunststoff besteht und die Mouldmasse ein Duroplast darstellt, entstehen hinsichtlich der formschlüssigen Verbindung der Steckerpins und dieser beiden Kunststoffe keine Probleme.

Die Umpressung 5 der Leiterplatte 2 ist so ausgeführt, daß noch ein Teil des von der Metallplatte 1 gebildeten umlaufenden Randes 4 von der Mouldmasse unbedeckt bleibt.

Durch das Moulden der kompletten Baugruppe entstehen mehrere Vorteile: es ergeben sich erhebliche Einsparungen bei den Steckern, da einmal der Steckerrahmen bei dem Steckerhersteller entfällt und zum anderen auch die Steckermontage einfacher wird. Weiterhin gibt es erhebliche Einsparungen bei den Gehäusewerkzeugen, da lediglich ein einziges Werkzeug zur Umpressung benötigt wird. Weiterhin wird die Größe einer solchen Baugruppe im Vergleich zu solchen aus dem Stand der Technik weiter verkleinert und auch deren Robustheit erhöht.

Bei der oben beschriebenen Baugruppe werden noch handelsübliche Bauelemente, also solche mit Gehäuse verwendet. Ein weiterer Kostenvorteil wird dadurch erreicht, daß lediglich IC-Chips (die), also Bauelemente ohne Gehäuse eingesetzt werden. Die elektrische Kontaktierung mit der Leiterplatte erfolgt dann über einen Bond-Prozeß. Die Kosteneinsparungen ergeben sich dann durch die nicht behäusten Bauelemente. Ein weiterer Vorteil ergibt sich durch die verbesserte Recyclingfähigkeit, da dann lediglich Kunststoffmaterial der gleichen Art anfällt.

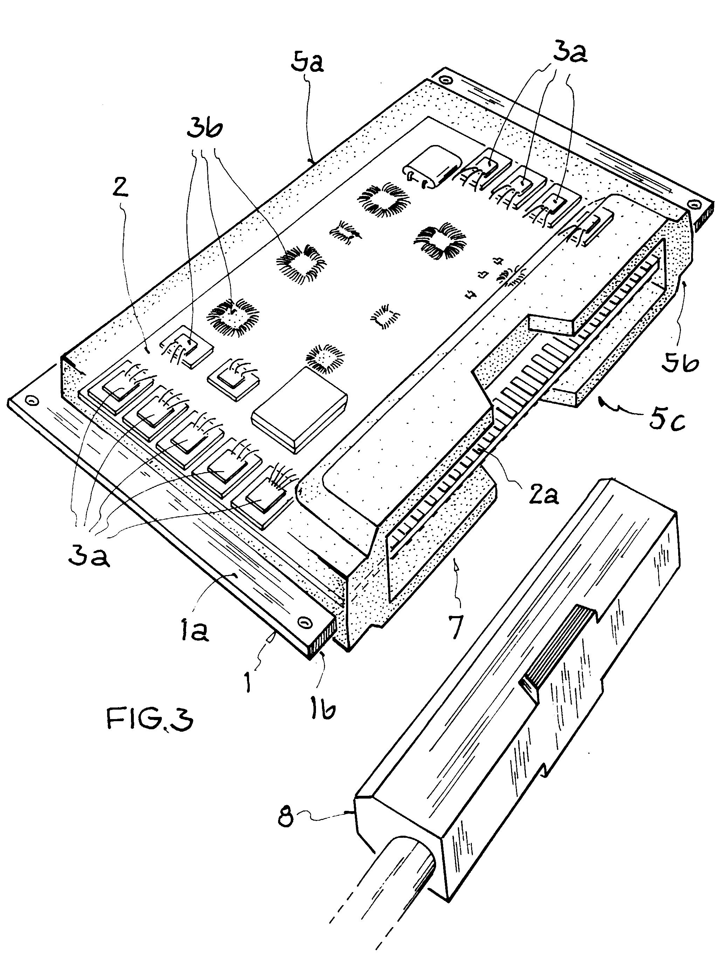

Bei der Baugruppe nach Figur 3 ergibt sich hinsichtlich des Steckers eine weitere Einsparung, da dieser durch einen Randgruppenstecker 8 ersetzt wird. Hierzu weist die Metallplatte 1 eine Aussparung 7 derart auf, daß in diese Aussparung ein Randbereich der Leiterplatte 2 ragt. In diesen Randbereich der Leiterplatte enden Leiterbahnzüge mit ihren Endkontakten 2a, die den Kontakt mit dem Randgruppenstecker 8 herstellen. Die Umpressung 5a der Leiterplatte weist in diesem Bereich ebenfalls einen Ausschnitt auf, da die Endkontakte 2a unbedeckt bleiben müssen. Da nunmehr die Rückseite der Leiterplatte 2 nicht mehr vollständig auf der Metallplatte 1 aufliegt, muß an der entsprechenden Verbindungsstelle zwischen der Rückseite der Leiterplatte und der Metallplatte für einen feuchtedichten Abschluß gesorgt werden. Dies erfolgt dadurch, daß mit der Umpressung der Leiterplatte 2 und deren Bauelemente gleichzeitig die Rückseite der Leiterplatte 2 bzw. die Fläche 1b der Metallplatte 1 umpreßt wird (vgl. Bezugsziffer 5b) unter Bildung eines Führungsschachtes 5c für den Stecker 8.

Ansonsten ist die Baugruppe nach Figur 3 entsprechend derjenigen nach den Figuren 1 und 2 aufgebaut.

Die in den Figuren beschriebenen Baugruppen enthalten eine Metallplatte mit einer Größe von ca. 120 cm². Die Erfindung ist nicht auf eine solche Größe beschränkt, sondern kann auch bei solchen Baugruppen eingesetzt werden, deren flächenhafte Ausdehnung noch größer ist.

Die hier beschriebenen Baugruppen können mit Vorteil in der Automobiltechnik eingesetzt werden. Daneben dürften sie auch überall dort zu finden sein, wo Logik und Leistung auf engstem Raum miteinander kombiniert oder wo "Smart-Power"-Module als Subsysteme in größere Systeme oder Aggregate integriert werden sollen. Dafür kommen neben der Automobiltechnik auch die Telekommunikation und die industrielle Elektronik in Frage, speziell auch in Einschubsystemen mit Wärmeabfuhr über die Aluminiumplatte auf den Gehäuserahmen. Hierbei ist eine beidseitige elektrische Steckverbindung über eine sogenannte Rückwandverdrahtung der Baugruppen untereinander möglich.

## Patentansprüche

1. Elektrische Baugruppe mit einer elektronische Bauelemente (3, 3a) tragenden Leiterplatte (2) und einer eine erste und zweite Fläche (1a, 1b) aufweisenden Metallplatte (1), wobei die Leiterplatte (2) formschlüssig auf der ersten Fläche (1a) der Metallplatte (1) angeordnet ist, gekennzeichnet durch folgende Merkmale:
a) die Metallplatte (1) weist eine solche Fläche auf, daß sie am Umfang der Leiterplatte (2) übersteht und
b) es ist eine Umpressung der Bauelemente (3, 3a) und der Leiterplatte (2) mittels einer Mouldmasse vorgesehen, wobei diese Umpressung mit dem am Umfang der Leiterplatte (2) überstehenden Teil der Metallplatte (1) eine formschlüssige Verbindung bildet.

2. Elektronische Baugruppe nach Anspruch 1, dadurch gekennzeichnet, daß die Metallplatte (1) am Umfang der Umpressung (5) übersteht.

3. Elektronische Baugruppe nach Anspruch 1 oder 2 mit einem mit der Leiterplatte verbundenen Stecker, der aus einem Steckerkern und einem Steckerrahmen aufgebaut ist, dadurch gekennzeichnet, daß der Steckerrahmen als Umpressung (6b) des Steckerkerns (6a) ausgebildet ist und diese zusammen mit derjenigen der Bauelemente (3, 3a) und der Leiterplatte (2) eine einzige Umpressung bilden.

4. Elektronische Baugruppe nach Anspruch 3, dadurch gekennzeichnet, daß der Stecker (6a, 6b) auf der zweiten Fläche (1b) der Metallplatte (1) angeordnet ist.

5. Elektronische Baugruppe nach Anspruch 1 oder 2, wobei Mittel zum Anschluß von Verbindungsleitungen vorgesehen sind, dadurch gekennzeichnet, daß zum Anschluß der Verbindungsleitungen ein Randgruppenstecker (8) verwendet wird.

6. Elektronische Baugruppe nach Anspruch 5, dadurch gekennzeichnet, daß zur Anbringung des Randgruppensteckers (8) die Metallplatte (1) im Randbereich eine Aussparung (7) aufweist, die so tief ist, daß ein zur Aufnahme des Randgruppensteckers (8) ausreichender Randbereich der Leiterplatte (2) in diese Aussparung (7) ragt und daß dieser Randbereich der Leiterplatte (2) nicht umpreßt wird.

7. Elektronische Baugruppe nach Anspruch 6, dadurch gekennzeichnet, daß auf der zweiten Fläche (1b) der Metallplatte (1) im Randbereich der Leiterplatte (2) eine Umpressung (5b) des Kontaktbereichs von Metallplatte (1) und Leiterplatte (2) vorgesehen ist, die zusammen mit derjenigen der Bauelemente (3, 3a) und der Leiterplatte (2) eine einzige Umpressung bildet.

8. Elektronische Baugruppe nach Anspruch 7, dadurch gekennzeichnet, daß mit der Umpressung (5a, 5b) ein Führungsrahmen (5c) für den Randgruppenstecker (8) gebildet wird.

9. Elektronische Baugruppe nach einem der Ansprüche 5 bis 8, dadurch gekennzeichnet, daß als Randgruppenstecker (8) ein Nullkraftstecker verwendet wird.

10. Elektronische Baugruppe nach einem der vorangehenden Ansprüche, dadurch gekennzeichnet, daß als elektronische Bauelemente (3, 3a) gehäuselose Halbleiter-Chips verwendet werden.

11. Elektronische Baugruppe nach einem der vorangehenden Ansprüche, dadurch gekennzeichnet, daß als Leiterplatte (1) eine Mehrlagen-Platine verwendet wird.

## Claims

1. An electrical assembly with a printed circuit board (2) bearing electronic components (3, 3a) and with a metal plate (1) having a first and second surface (1a, 1b), where the printed circuit board (2) is arranged interlockingly on the first surface (la) of the metal plate (10, characterised by the following features:
a) the metal plate (1) has a surface such that it projects at the periphery of the printed circuit board (2) and
b) an extrusion-coating of the components (3, 3a) and of the printed circuit board (2) by means of a moulding compound is provided, where this extrusion-coating forms an interlocking connection with that part of the metal plate (1) projecting at the periphery of the printed circuit board (2).

2. An electronic assembly as claimed in Claim 1,
characterised in that the metal plate (1) projects at the periphery of the extrusion-coating (5).

3. An electronic assembly as claimed in Claim 1 or 2 with a plug which is connected to the printed circuit board and which is constructed from a plug core and a plug housing, characterised in that the plug housing is designed as extrusion-coating (6b) of the plug core (6a) and this extrusion-coating forms one single extrusion-coating together with the extrusion-coatings of the components (3, 3a) and of the printed circuit board (2).

4. An electronic assembly as claimed in Claim 3,
characterised in that the plug (6a, 6b) is arranged on the second surface (1b) of the metal plate (1).

5. An electronic assembly as claimed in Claim 1 or 2, where means are provided for the connection of connecting leads,
characterised in that a multiple edge connector (8) is used for the connection of the connecting leads.

6. An electronic assembly as claimed in Claim 5,
characterised in that for the application of the multiple edge connector plug (8) the metal plate (1) is provided in its peripheral region with a recess (7), the depth of which recess is such that a peripheral region of the printed circuit board (2) adequate to accommodate the multiple edge connector (8) projects into this recess (7) and that this peripheral region of the printed circuit board (2) is not extrusion-coated.

7. An electronic assembly as claimed in Claim 6,
characterised in that on the second surface (1b) of the metal plate (1) in the peripheral region of the printed circuit board (2) an extrusion-coating (5b) of the contact zone of metal plate (1) and printed circuit board (2) is provided, which extrusion-coating (5b) forms one single extrusion-coating with the extrusion-coatings of the components (3, 3a) and of the printed circuit board (2).

8. An electronic assembly as claimed in Claim 7,
characterised in that a guide frame (5c) for the multiple edge connector (8) is formed with the extrusion-coating (5a, 5b).

9. An electronic assembly as claimed in one of Claims 5 to 8, characterised in that a zero-force plug is used as multiple edge connector (8).

10. An electronic assembly as claimed in one of the preceding claims, characterised in that housing-free semiconductor chips are used as electronic components (3, 3a).

11. An electronic assembly as claimed in one of the preceding claims, characterised in that a multi-layer board is used as printed circuit board (1).

## Revendications

1. Module électronique comprenant une carte imprimée (2) portant des composants électroniques (3, 3a), ainsi qu'une plaque métallique (1) présentant une première et une seconde face (1a, 1b), la carte imprimée (2) étant disposée à complémentarité de formes sur la première face (1a) de la plaque métallique (1), caractérisé en ce que:
a) la plaque métallique (1) présente une surface telle qu'elle déborde de la périphérie de la carte imprimée (2) et
b) les composants (3, 3a) et la carte imprimée (2) sont enrobés par moulage au moyen d'une masse de moulage et cet enrobage établit une liaison à complémentarité de formes avec la partie de la plaque métallique (1) faisant saillie de la périphérie de la carte imprimée (2).

2. Module électronique selon la revendication 1, caractérisé en ce que la plaque métallique (1) dépasse de la périphérie de l'enrobage (5).

3. Module électronique selon la revendication 1 ou 2 et comprenant un connecteur relié à la carte imprimée et constitué d'un noyau et d'un encadrement, caractérisé en ce que l'encadrement du connecteur est réalisé comme un enrobage (6b) du noyau (6a) du connecteur et que cet enrobage forme avec celui des composants (3, 3a) et de la carte imprimée (2) un enrobage unique.

4. Module électronique selon la revendication 3, caractérisé en ce que le connecteur (6a, 6b) est placé sur la seconde face (1b) de la plaque métallique (1).

5. Module électronique selon la revendication 1 ou 2 et comprenant des moyens pour le raccordement de conducteurs de liaison, caractérisé en ce qu'un connecteur de groupage marginal (8) est utilisé pour le raccordement des conducteurs de liaison.

6. Module électronique selon la revendication 5, caractérisé en ce que, pour la mise en place du connecteur de groupage marginal (8), la plaque métallique (1) présente, dans une zone de son bord, un évidement (7) d'une profondeur telle qu'une zone marginale de la carte imprimée (2), zone qui est suffisante pour recevoir le connecteur (8), fait saillie dans cet évidement (7), et que cette zone marginale de la carte imprimée (2) n'est pas enrobée par moulage.

7. Module électronique selon la revendication 6, caractérisé en ce que, sur la seconde face (1b) de la plaque métallique (1), on a prévu, dans la zone marginale de la carte imprimée (2), un enrobage (5b) de la zone de contacts de la plaque métallique (1) et de la carte imprimée (2), qui forme un enrobage unique avec celui des composants (3, 3a) et de la carte imprimée (2).

8. Module électronique selon la revendication 7, caractérisé en ce que l'enrobage (5a, 5b) forme un encadrement de guidage (5c) pour le connecteur de groupage marginal (8).

9. Module électronique selon une des revendications 5 à 8, caractérisé en ce que le connecteur de groupage marginal (8) est un connecteur dont les contacts ne sont soumis à aucune force transmise par les conducteurs reliés à eux.

10. Module électronique selon une des revendications précédentes, caractérisé en ce que les composants électroniques (3, 3a) sont des puces à semi-conducteurs sans boîtier.

11. Module électronique selon une des revendications précédentes, caractérisé en ce que la carte imprimée (1) est une platine à plusieurs couches.
